# EUROPEAN PATENT SPECIFICATION

(11) **EP 0 934 614 B1**
(45) Date of publication and mention of the grant of the patent: **02.01.2004**
(21) Application number: 96937765.4
(22) Date of filing: 28.10.1996
(51) Int. Cl.: H01R 29/00, H02B 1/20, H05K 1/00, H05K 3/20

(54) **VEHICLE POWER DISTRIBUTION BOX**
VERTEILERKASTEN FÜR FAHRZEUGE
BOITE DE DISTRIBUTION ELECTRIQUE POUR VEHICULE

(43) Date of publication of application: 11.08.1999
(73) Proprietor: Cooper Industries, Inc., Houston, Texas 77002 (US)
(72) Inventor: KORCZYNSKI, Jacek, Niles, IL 60714 (US); SPENCER, Ronald, Lee, Chesterfield, MO 63005 (US)
(74) Representative: Brunner, Michael John
(86) International application number: PCT/US1996/017208
(87) International publication number: WO 1998/019371

(56) References cited:
- EP-A- 0 327 994
- WO-A-96/05640
- US-A- 3 072 734
- US-A- 3 408 452
- US-A- 3 701 964

## Description

This invention relates generally to a distribution system for electric power, and in particular to an electrical power distribution system for a vehicle.

The first motorized vehicles had little in the way of an electrical system. All that was required was some way to generate and distribute an ignition potential to each of the cylinders of the small, internal combustion engine that powered these early vehicles.

The need to see the road ahead during nighttime operation gave rise to the first electrical accessory: headlights. Interior illumination was added for the operator's convenience, and a single tail light was considered adequate. Turn signal lights followed, but the simple vehicle radio receiver did not make its appearance until a number of years later.

The modem automobile is an impressive collection of electrical hardware: from stereo sound equipment to air conditioning; from power windows, mirrors and seats to keyless entry systems; from vehicle alarms to scat position memory to electrically heated seats. The complexity of vehicle electrical systems has grown almost exponentially since the automobile's introduction.

Automotive and truck electrical systems are a formidable combination of high-current and low-current circuitry. In many cases, relays are required for control purposes, and all circuits must be adequately fused to protect expensive components and to guard against the danger of fire. In order to facilitate the replacement of fuses and relays, and to simplify interconnection of electrical hardware, many different electric power distribution systems have been tried.

One approach that has been tried with fair consistency is to centralize fuse and relay mounting, then route input and output connections from this central location. The first systems built using this approach included a great deal of point-to-point wiring. Hand wiring is very costly, and manual wiring operations are a source of wiring errors that negatively impact product quality. In addition, massive wiring bundles create a hazard of shorts or fire.

Another approach has been the construction of customized distribution networks stamped as strips from thin metal sheets - "stamp tracks." These stamp tracks are formed metal sheets that have contact tabs protruding through openings in custom designed plastic shells. Although this approach yields a higher quality product, tooling costs are very high, since virtually every automobile model requires a unique distribution system. At least some of this uniqueness aspect is driven by the proliferation of fuse and relay packages. A distribution product must be able to accommodate the fuse and relay components selected by the manufacturer.

Yet another approach has centred around the use of flexible circuit board technology, or "flex circuits." Flex circuits are constructed by depositing conductive material between two flexible insulating layers. Although the unique distribution requirements of each vehicle model would require unique flex circuits for each application, tooling costs are much lower than the metal stamping/custom plastic housing approach described previously. The principal disadvantage of the flex circuit approach is that the conductive layers are very thin, and the high current densities required in vehicle power distribution lead to overheating and eventual failure.

Consequently, a need arises fora vehicle electric power distribution system that can be customized for a particular vehicle with relative ease, that avoids high tooling costs for custom designed components, that is reliable in a high current environment, that will accommodate a wide range of fuse and relay packages, and that is relatively inexpensive to manufacture.

In our WO-A-96/05640, we describe a power distribution apparatus having a conductive plate, said conductive plate including a plurality of contact pads that are interconnected by removable connecting links; each of the contact pads including means for receiving a connector pin; a plurality of removable connector links interconnecting the contact pads, wherein discrete circuits can be formed on said conductive plate by selectively removing a portion of said removable connector links; a non-conductive plate adjacent said conductive plate, said conductive plate and said non-conductive plate having matching openings; a plurality of connector pins extending through a portion of said openings to form electric contacts; a housing for retaining said non-conductive plate and said conductive plate, said housing including receptacles for connector assemblies that engage with said electric contacts.

The present is characterised over our prior disclosure in that said non-conductive plate includes recesses adjacent said openings a side of said non-conductive plate facing said conductive plate for entrapping a hilt on each of said pins.

Preferably, at least one receptacle is located on each of a first and a second side of the housing.

The contact pads are preferably arranged in a rectangular array.

Furthermore, preferably, each of said receiving means is a rectangular slot extending through said conductive plate.

Preferably, at least one of said plurality of pins includes a portion larger than said openings and is received in said at least one recess, thereby securing said pin between said conductive plate and said non-conductive plate.

The invention also includes a method of assembling a power distribution apparatus, comprising the steps of:
providing a conductive plate, said conductive plate including a plurality of contact pads that are interconnected by removable connecting links;
providing a non-conductive plate adjacent said conductive plate;
selectively removing a portion of said connecting links to form discrete circuits on said conductive plate;
mounting contact pins to selected contact pads;
mounting the conductive plate within a housing such that the mounted contact pins line up with connector receptacles in the housing for receiving plug-in connectors; and characterised by
securing a portion of each of said contact pins between said conductive plate and said non-conductive plate.

One example of apparatus according to the present invention will now be described with reference to the accompanying drawings, in which:-
Fig. 1 is a perspective view of the present invention;
Fig. 2 is a cross section taken along line 20 of Fig. 1;
Fig. 3 is a cross section taken along line 21 of Fig 1;
Fig. 4 is a plan view of a conductive plate used in the embodiment of Fig. 1;
Fig. 5 is a plan view of an insulating plate used in the embodiment of Fig. 1;
Fig. 6 is a cross section of the plates of Figs. 4 and 5 used together, taken along line 24 of Fig. 4;
Fig. 7 is a cross section of the plates of Figs. 4 and 5 used together taken along the line 25 of Fig. 4; and
Fig. 8 illustrates a specific circuit using the embodiment of Fig. 1.

We have developed a reliable, low-cost electric power distribution system which finds particular use in a vehicle. However, the invention described is not limited to vehicle applications and can be used for any operation which requires a power distribution panel capable of supporting a wide range electrical wiring architecture. We provide a conduction circuit plate that has a repeating pattern of openings and shaped cut-outs. The shaped cut-outs are arranged so that the material left surrounding the openings define electrical circuit paths extending from and interconnecting each opening. The desired circuit path is created by selectively electrically isolating openings and their surrounding material from other openings and their surrounding material. Multiple circuit plates may be stacked to provide a desired distribution panel. An interconnection between the staked circuit plates may be accomplished by using connective pins positioned in the openings to interconnect the circuits defined on successive circuit plates. The placement of the openings is such that they accommodate standard circuit elements i.e., fuses, relays, etc., which may be installed in the formed circuit paths. With the addition of these active circuit elements, a complete panel is capable of serving as the central processor for the entire vehicle. The invention can best be understood with reference to the accompanying drawing figures.

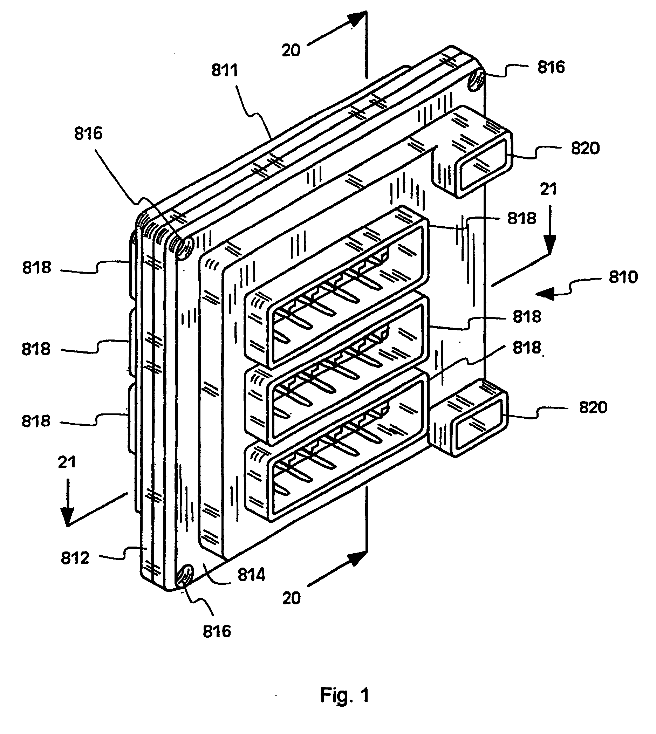

Figure 1 illustrates the present invention, which is sometimes referred to as a splicing box (810). The splicing box of Figure 1 works according to the same principles as our prior disclosure WO-A-96/05640.

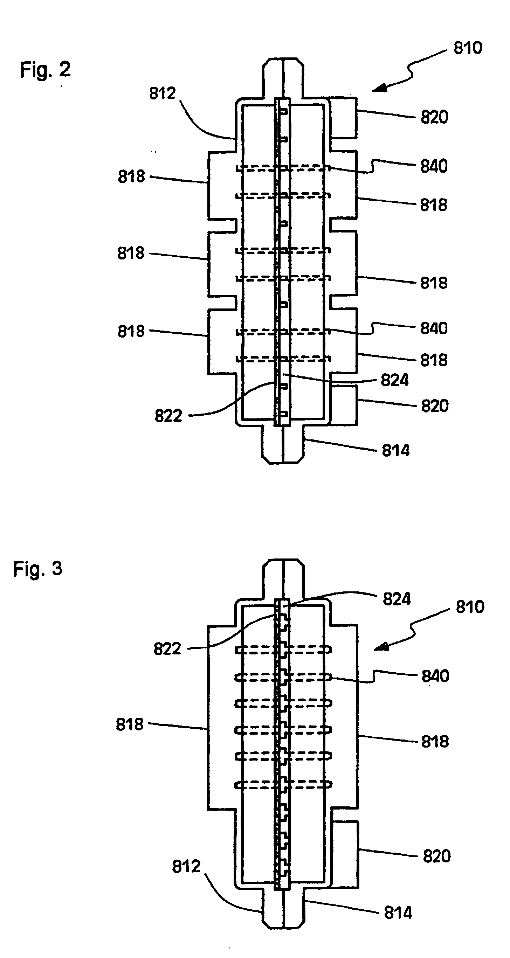

Figures 2 and 3 are cross-sectional views of the splicing box of Figure 1. The splicing box (810) includes a nonconductive housing (811), preferably made from a thermoplastic polyester, which may be reinforced with 30% glass. However, one of skill in the art could identify other materials that may be used, instead. The housing (811) is preferably made from two halves (812, 814). The two halves of the housing may be secured by screws (816), or any other suitable means.

The housing (811 ) may include one or more openings or receptacles (818) for receiving connector assemblies (not shown). The receptacles (818) may be provided with a latch, or some kind of detente mechanism to releasably retain the connector within the receptacles (818). In addition, smaller openings or receptacles (820) may also be provided in the housing for receiving fuses or smaller electrical components.

In the particular embodiment illustrated the receptades (818) on one housing side (812) are in alignment with the receptacles (818) on the other housing side (814). However, it is not necessary for the receptacles (818) to be in alignment with each other. In fact, it is possible to have receptacles on only one side of the housing (811). The particular arrangement of connector receptacles depends on the application of the splicing box (810).

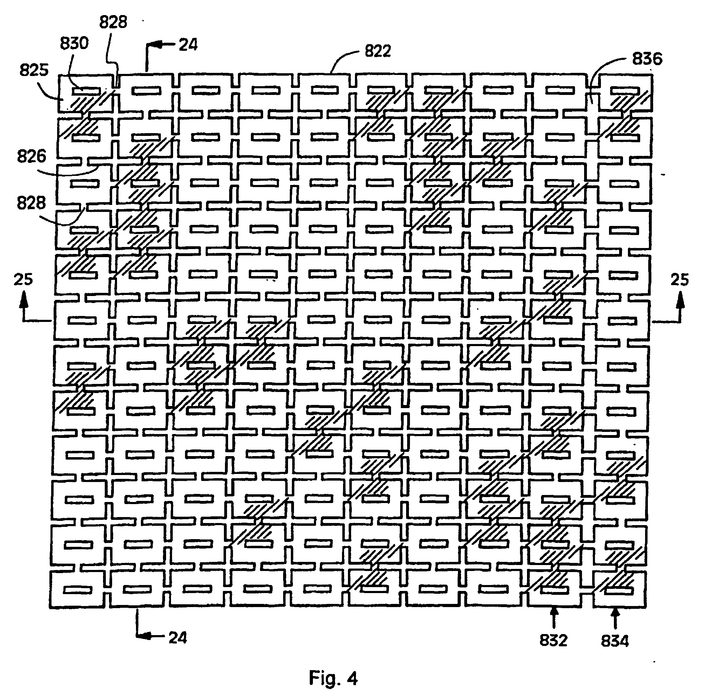

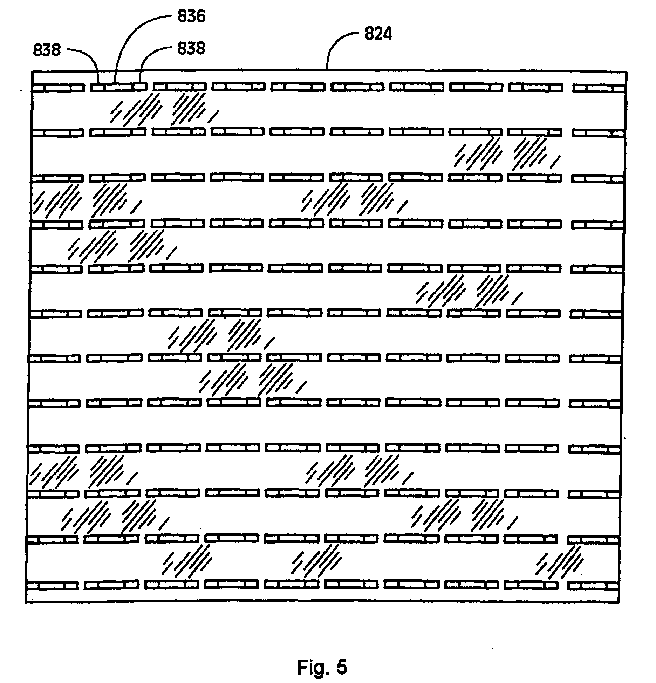

Turning attention now to Figures 4 and 5, inside the housing are located a conductive plate (822) and an insulative plate (824). The conductive plate (822) includes a plurality of contact pads (825), which are preferably arranged in a rectangular grid pattern. However, the contact pads (825) may be arranged in any other design suitable for its intended purpose.

The contact pads (825) are separated from each other by cut-outs (826), such as cross-shaped cutouts. The arrangement of the cut-outs (826) leaves a plurality of connecting surfaces (828) joining adjacent contact pads (825). Electrical connection between adjacent contact pads (825) can be prevented by severing the connecting surfaces (828) between the two contact pads (825). In addition, an opening (830) is provided in each contact pad (825). In a preferred embodiment, the spacing between each column of contact pads (825) is uniform, with the exception of the last two columns. The spacing between the columns of contact pads is arranged to correspond to standard spacing between contacts in a connector assembly. In one embodiment, the columns of contact pads (825) are spaced at 6.9 mm, and the rows are spaced at 6.75 mm. However, any suitable spacing may be used.

The spacing between the last two columns is slightly larger than the spacing between the remaining columns in orderto accommodate contacts from a fuse or other electrical components. In a preferred embodiment, the spacing between the last two columns (832, 834) is set at 8.1 mm to accommodate a standard automotive fuse, such as an ATM-style minifuse manufactured by the Bussmann Division of Cooper Industries, Inc. However, otherspacings may be used. Other devices that may be used in the receptacles (820) include mini-circuit breakers, ATC circuit breakers, relays, flashers and diodes. In a preferred embodiment, the smaller receptacles (820) in the housing (811) are designed to line up with the last two columns (832, 834) of the conductive plate (822). When the conductive plate (822) is in place within the housing (811 ), one opening (830) from column (832) and one opening (830) from column (834) are aligned with one of the receptacles (820) so as to accommodate the contacts from a device inserted into the receptacle (820). Another opening (830) from column (832) and another opening (830) from column (834) are aligned with the other of the receptacles (820).

The spacing of the columns of contact pads (825) is not critical to the present invention. The arrangementof the contact pads (825) may include any numberof rows and columns, with either regular or irregular spacing. In fact, it is not necessary that the contact pads (825) be arranged in rows and columns, provided that they are connected by connecting surfaces that can be easily severed.

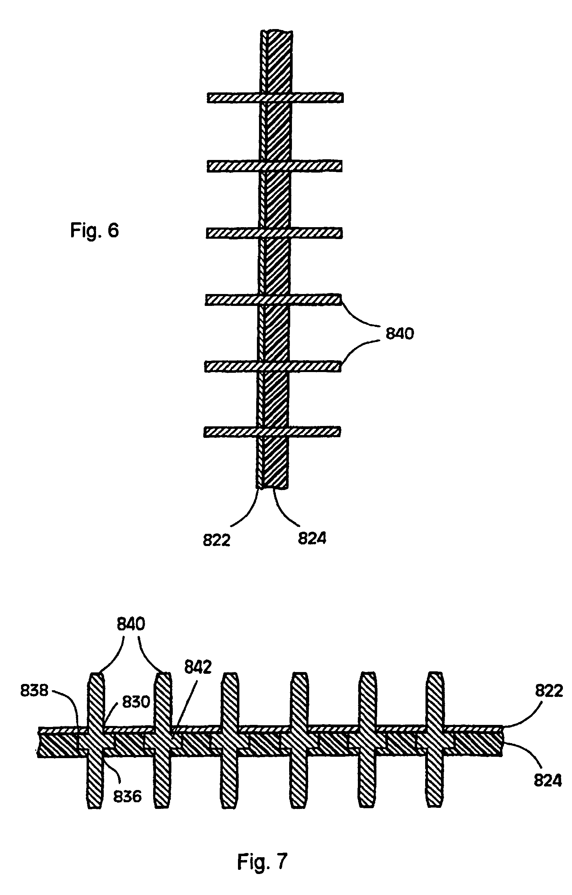

Turning attention now to Figure 5, a nonconductive, insulative sheet or plate (824) is preferably, although not necessarily, provided with the same outer dimensions as the conductive plate (822). The nonconductive plate (824) includes a plurality of openings (836). Each of the openings (836) in the nonconductive plate (824) is aligned with a corresponding opening (830) in the conductive plate (822) when the conductive plate (822) and the nonconductive plate (824) are placed together, as shown in FIGS. 6 and 7. In addition to the openings (836), there are recessed areas (838) on each side of each opening (836) on one side of the plate (824). The specific arrangement of the recesses (838) and openings (836) can be better appreciated from Figure 7. The specific shape of the openings (836) and recesses (838) in the nonconductive plate (824) are intended to facilitate retaining pins (840) in place within the conductive plate (822).

The pins (840) are made from a conductive material and are preferably of a size which fits tightly within the openings (830). The pins (840) may be tin or solder plated for corrosion protection.

In addition, each pin (840) include a hilt (842). The hilt (842) is larger than the openings (830) in the conductive plate (822), and thus prevents the pin (840) from passing all the way through the openings (830) in the conductive plate (822). The size and shape of the hilt (842) of each pin (840) correspond to the recesses (838) associated with the openings (836) in the nonconductive plate (824). Accordingly, when pins (840) are inserted through the openings (830) in the conductive plate (822), and the nonconductive plate (824) is arranged adjacent the conductive plate (822), as illustrated in Figures 6 and 7, the pins (840), by means of the hilts (842), are trapped between the conductive plate (822) and the nonconductive plate (824).

The pins (840) illustrated in this preferred embodiment have a cross-sectional shape that is substantially rectangular. However, the pins may be cylindrical, or any other shape. As best seen in Figures 2 and 3, the assembly of the nonconductive plate (824), the conductive plate (822), and pins (840) fit between the two housing halves (812, 814). It is not necessary or intended to provide pins (840) extending through every one of the openings (830) in the conductive plate (822). Instead, pins (840) are only inserted through the particular openings (830) that are intended to be in alignment with the receptacles (818), and which are necessary to form a connection with a connector (not shown) that may be plugged into the receptacles (818). The receptacles (818) may be provided with a latch, or some kind of detente mechanism to releasably retain the connector within the receptacles (818).

As an alternative, pins could be arranged that do not protrude from both sides of the conductive plate (822), but instead protrude from only one side of the plate (822). One embodiment could use some pins that protrude from both sides of the plate (822) and some pins that protrude from only one side of the plate (822). Pins that protrude from only one side of the plate may be secured by laser welding, or any other suitable attachment mechanism.

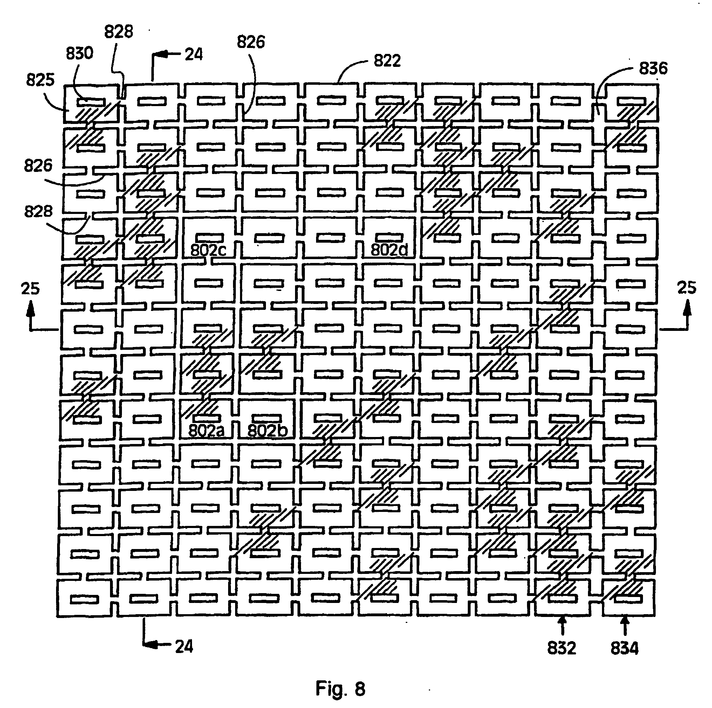

By selectively severing the connecting surfaces (828) between certain contacts pads (825), a wiring circuit may be constructed, wherein a circuit may be completed between two or more pins, as desired. For example, in the example shown in Figure 8, several connecting surfaces (828) have been removed thus isolating contact pads (802a, 802b, 802c, and 802d). In addition, the contact pads between contact pads (802c) and (802d) and the contact pads between contact pad (802a) and contact pad (802c) are also connected. These contact pads (802a) through (802d) form a circuit that is isolated from the remainder of the conducting plate (822). Thus, pins extending through the openings (830) in contact pads (802a, 802b, 802c, and 802d) can be used to make connection with connecting blocks plugged into the receptacles (818).

In an actual example, there would likely be several independent circuits formed on one plate (822).

In the embodiments illustrated the nonconducting plate (824) lies adjacent to the conducting layer (822), and is held in place within the housing (811) by the housing halves (812, 814). It is not necessary for the nonconducting plate (824) to be coated onto the conductive plate (824), or to otherwise use an adhesive to adhere the two plates (822, 824) together. Pressure from the two housing halves (812, 814) is sufficient to retain the two plates (822, 824) together. Nevertheless, one of ordinary skill in the art would appreciate that the nonconductive plate (824) could be adhered to the conductive plate (822) with an adhesive.

Alternatively, instead of using a distinct nonconductive plate (824), a layer of nonconductive material could be coated or insert molded onto the conductive plate (824), in a manner similar to the previously disclosed embodiments. In such an embodiment, the pins (840) may also be secured by friction, laser welding, or some other manner readily available to those of skill in the art.

Preferably, the conductive plate (822) in the Figure 1 embodiment is a metal sheet having a thickness of about 0.5 to 1.3 mm. Other conductive materials of different thicknesses could be used, depending upon the intended use of the device. For vehicle uses, the preferred metal is copper. However, brass or stainless steel may also be used. In one embodiment, the conductive plate (822) may be stamped from a 0.8 mm CDA 110 half-hard copper. The thickness of the plate may be determined by the current requirements, wherein higher currents would require thicker plates. Currents of up to 30 amps can be used with the 0.8 mm copper plate. From a practical point of view; the actual limitations on currents are likely determined by the connectors used with the splicing box, rather than the thickness of the plate. Voltages of up to 50 Volts DC may be easily accommodated.

In general, the splicing box (810) and the power distribution boxes disclosed in this disclosure may be used to power almost any and all of the electrical devices in a vehicle, with the exception of the spark plug power. The power for the headlights, air conditioning, radios, etc. may all be distributed through either the splicing box, the power distribution box, or a combination of both.

To facilitate subsequent soldering operations, the plate (822) may be solder plated or coated to provide a solder layer thickness of about .005 to about .010 mm. The conductive material may be preplated or coated before the stamping operation, or a plating or coating may be added later. One of the preferred solder compositions for a copper base is a tin solder composition. Of course, other suitable compositions, known to those skilled in the art may be substituted for the solder just described.

The nonconductive plate (824) may be made from any suitable nonconductive material. In a preferred embodiment, the nonconductive plate (824) is made from Rynite FR530, 94v-0, manufactured by El. Dupont Company. This material is described as a PET (polyethylene terephthalates) thermoplastic material. However, any number of insulating plastic or other materials would serve in this application.

According to another feature of the present invention, the terminal spring (501), illustrated in Figures Sa through Sc, and described above, may be used in combination with the pins (840) of the Figure 1 embodiment.

When programming the conductive plate (822), i.e., stamping out the undesired connecting surfaces (828) from the conductive plate (822), it will become apparent that one or more groups of contact pads (825) may be completely isolated from the remainder of the conductive plate (822). See for example contact pads (802a, 802b, 802c, and 802d) in Figure 8. In order to retain the "island" of contact pads in its respective place within the conductive plate (822), a layer of thin, nonconductive tape may be adhered to one surface of the conductive plate (822). Thus, as the connecting surfaces (828) are severed from the conductive plate (822), any islands of contact pads will retain their proper relative position because of the tape. If the nonconductive plate (824) is secured to the conductive plate (822) with an adhesive, the use of the tape to retain the islands of contact pads will not be necessary.

After the pins have been inserted and locked between the conductive plate (822) and nonconductive plate (824), the plates and pins (840) may be secured by heating the assembly in order to reflow the solder coating on the conductive plate (822). The reflowing of the solderenhances the electrical connection between the plate (822) and the pins (840), and helps to secure the pins (840) within the plate (822). As an alternative to using reflowed solder, a laser welding process may be used to secure the pins (840) to the plate (822). In such a case, there is no need to coat the plate (822) with solder.

Although the Figure 1 embodiment discloses only one conductive plate (822) and one nonconductive plate (824), any combination of conductive and nonconductive plates may be used, provided that the conductive plates are separated by nonconductive plates or layers. For example, a device may include one conductive layer surrounded by two nonconductive layers. Alternatively, it is possible that a single conductive plate may be used without a nonconductive plate or layer. However, in such a case, it may be necessary to use a layer of taper or adhesive on the conductive plate (822) to retain any islands of pads in their proper place.

In an embodiment using more than one conductive plate (822), it may be necessary to enlarge some of the openings (830) so that some of the pins (840) extending through some of the holes (830) do not make contact with the conductive pad (825) surrounding the opening (830). This principle is much the same as that set forth above with respect to opening (703a), illustrated in our prior disclosure of WO-A-96/05640, and described above.

It is not necessary for the nonconductive plates to be adhered to or coated onto the conductive plates in order to form the completed assembly.

The inventors have described herein an electric power distribution apparatus and a splicing box that are inexpensive to produce, easily adapted for specific model applications, and durably packaged. Although several of the inventive features are described with particularity in the appended claims, it should be understood that there may be variations of the inventive concept that, while not explicitly claimed, nonetheless fall within the scope of the invention.

## Claims

1. A power distribution apparatus comprising:
a conductive plate (822), said conductive plate (822) including a plurality of contact pads (825) that are interconnected by removable connecting links (828);
each of the contact pads (825) including means for receiving a connector pin (840);
a plurality of removable connector links (828) interconnecting the contact pads (825), wherein discrete circuits can be formed on said conductive plate (822) by selectively removing a portion of said removable connector links (828);
a non-conductive plate (824) adjacent said conductive plate (822), said conductive plate (822) and said non-conductive plate (824) having matching openings (830, 836);
a plurality of connector pins (840) extending through a portion of said openings (836) to form electric contacts (707);
a housing (811) for retaining said non-conductive plate (824) and said conductive plate (822), said housing (811) including receptacles (818) for connector assemblies that engage with said electric contacts (707) and **characterised in that**
said non-conductive plate (824) includes recesses (838) adjacent said openings (836) on a side of said non-conductive plate (824) facing said conductive plate (822) for entrapping a hilt (842) on each of said pins (840).

2. A power distribution apparatus according to claim 1, wherein the housing (811) comprises a first side (812) and a second side (814) and wherein at least one receptacle (818) is located on each of the first (812) and second (814) sides of the housing (811).

3. The power distribution apparatus of claim 1 or claim 2, wherein said contact pads (825) are arranged in a rectangular array.

4. The power distribution apparatus of any of claims 1 to 3, wherein each of said receiving means (830) is a rectangular slot extending through said conductive plate (822).

5. A power distribution apparatus according to any preceding claim, wherein at least one of said plurality of pins (840) includes a hilt larger than said opening (830, 836) and is received In sold at least one recess (838), thereby securing said pin (840) between said conductive plate (822) and said non-conductive plate (824).

6. A method of assembling a power distribution apparatus, comprising the steps of:
providing a conductive plate (822), said conductive plate (822) including a plurality of contact pads (825) that are interconnected by removable connecting links (828);
providing a non-conductive plate (824) adjacent said conductive plate (822);
selectively removing a portion of said connecting links (828) to form discrete circuits on said conducive plate (822);
mounting contact pins (840) to selected contact pads (825);
mounting the conductive (822) within a housing (811) such that the mounted contact pins (840) line up with connector receptades (818) in the housing (811) for receiving plug-in connectors: and **characterised by**
securing a portion of each of said contact pins (840) between said conductive plate (822) and said non-conductive plate (824).

## Patentansprüche

1. Stromverteilungsvorrichtung, die umfasst:
eine leitende Platte (822), wobei die leitende Platte (822) eine Vielzahl von Kontaktflecken (825) enthält, die durch entfernbare Verbindungsglieder (828) miteinander verbunden sind;
wobei jeder der Kontaktflecken (825) eine Einrichtung zum Aufnehmen eines Verbinderstiftes (840) enthält;
eine Vielzahl entfernbarer Verbindungsglieder (828), die die Kontaktflecken (825) miteinander verbinden, wobei separate Schaltungen auf der leitenden Platte (822) ausgebildet werden können, indem selektiv ein Teil der entfernbaren Verbindungsglieder (828) entfernt wird;
eine nichtleitende Platte (824), die an die leitende Platte (822) angrenzt, wobei die leitende Platte (822) und die nichtleitende Platte (824) zueinander passende Öffnungen (830, 836) haben;
eine Vielzahl von Verbinderstiften (840), die sich durch einen Teil der Öffnungen (836) hindurcherstrecken, um elektrische Kontakte (707) zu bilden;
ein Gehäuse (811), das die nichtleitende Platte (824) und die leitende Platte (822) hält, wobei das Gehäuse (811) Aufnahmen (818) für Verbinderanordnungen enthält, die mit den elektrischen Kontakten (707) in Eingriff kommen, **dadurch gekennzeichnet, dass**:
die nichtleitende Platte (824) Aussparungen (838) an die Öffnungen (836) auf einer Seite der nichtleitenden Platte (824) angrenzend enthält, die der leitenden Platte (822) zugewandt ist, um ein Heft (842) an jedem der Stifte (840) einzuschließen.

2. Stromverteilungsvorrichtung nach Anspruch 1, wobei das Gehäuse (811) eine erste Seite (812) und eine zweite Seite (814) umfasst, und wobei sich wenigstens eine Aufnahme (818) an der ersten (812) sowie der zweiten (814) Seite des Gehäuses (811) befindet.

3. Stromverteilungsvorrichtung nach Anspruch 1 oder Anspruch 2, wobei die Kontaktflecke (825) in einer rechteckigen Anordnung angeordnet sind.

4. Stromverteilungsvorrichtung nach einem der Ansprüche 1 bis 3, wobei jede der Aufnahmeeinrichtungen (830) ein rechteckiger Schlitz ist, der sich durch die leitende Platte (822) hindurch erstreckt.

5. Stromverteilungsvorrichtung nach einem der vorangehenden Ansprüche, wobei wenigstens einer der Vielzahl von Stiften (840) ein Heft enthält, das größer ist als die Öffnung (830, 836) und in der wenigstens einen Aussparung (838) aufgenommen ist, um so den Stift (840) zwischen der leitenden Platte (822) und der nichtleitenden Platte (824) zu befestigen.

6. Verfahren zum Zusammensetzen einer Stromverteilungsvorrichtung, das die folgenden Schritte umfasst:
Bereitstellen einer leitenden Platte (822), wobei die leitende Platte (822) eine Vielzahl von Kontaktflecken (825) enthält, die durch entfembare Verbindungsglieder (828) miteinander verbunden sind;
Bereitstellen einer nichtleitenden Platte (824) an die leitende Platte (822) angrenzend;
selektives Entfernen eines Teils der Verbindungsglieder (828), um separate Schaltungen auf der leitenden Platte (822) auszubilden;
Anbringen von Kontaktstiften (840) an ausgewählten Kontaktflecken (825);
Anbringen der leitenden Platte (822) in einem Gehäuse (811), so dass die angebrachten Kontaktstifte (840) auf Verbinderaufnahmen (818) in dem Gehäuse (811) ausgerichtet sind, um Steckverbinder aufzunehmen; und **gekennzeichnet durch:**
Befestigen eines Abschnitts jedes der Kontaktstifte (840) zwischen der leitenden Platte (822) und der nichtleitenden Platte (824).

## Revendications

1. Appareil de distribution électrique comprenant :
une plaque conductrice (822), ladite plaque conductrice (822) comprenant une pluralité de patins de contact (825) qui sont interconnectés par des liaisons de connexion amovibles (828) ;
chacun des patins de contact (825) comprenant des moyens de réception d'une broche de connecteur (840) ;
une pluralité de liaisons de connexion amovibles (828) interconnectant les patins de contact (825), dans lesquelles des circuits discrets peuvent être formés sur ladite plaque conductrice (822) en enlevant sélectivement une partie desdites liaisons de connexion amovibles (828) ;
une plaque non conductrice (824) adjacente à ladite plaque conductrice (822), ladite plaque conductrice (822) et ladite plaque non conductrice (824) ayant des ouvertures correspondantes (830, 836) ;
une pluralité de broches de connecteurs (840) s'étendant à travers une partie desdites ouvertures (836) pour former des contacts électriques (707) ;
un boîtier (811) pour maintenir ladite plaque non conductrice (824) et ladite plaque conductrice (822), ledit boîtier (811) comprenant des embases (818) pour des ensembles de connecteurs qui se mettent en prise avec lesdits contacts électriques (707) et **caractérisé en ce que** :
ladite plaque non conductrice (824) comprend des renfoncements (838) adjacents auxdites ouvertures (836) sur un côté de ladite plaque non conductrice (824) faisant face à ladite plaque conductrice (822) pour piéger une poignée (842) sur chacune desdites broches (840).

2. Appareil de distribution électrique selon la revendication 1, dans lequel le boîtier (811) comprend un premier côté (812) et un second côté (814) et dans lequel au moins une embase (818) se trouve sur chacun du premier côté (812) et du second côté (814) du boîtier (811).

3. Appareil de distribution électrique selon la revendication 1 ou 2, dans lequel lesdits patins de contact (825) sont agencés dans une disposition rectangulaire.

4. Appareil de distribution électrique selon l'une quelconque des revendications 1 à 3, dans lequel chacun desdits moyens de réception (830) est une fente rectangulaire s'étendant à travers ladite plaque conductrice (822).

5. Appareil de distribution électrique selon l'une quelconque des revendications précédentes, dans lequel au moins une de ladite pluralité de broches (840) comprend une poignée plus grande que ladite ouverture (830, 836) et est reçue dans ledit au moins un renfoncement (838), ce qui fixe ladite broche (840) entre ladite plaque conductrice (822) et ladite plaque non conductrice (824).

6. Procédé d'assemblage d'un appareil de distribution électrique comprenant les étapes consistant à :
fournir une plaque conductrice (822), ladite plaque conductrice (822) comprenant une pluralité de patins de contact (825) qui sont interconnectés par des liaisons de connexion amovibles (828) ;
fournir une plaque non conductrice (824) adjacente à ladite plaque conductrice (822);
enlever sélectivement une partie desdites liaisons de connexion (828) pour former des circuits discrets sur ladite plaque conductrice (822) ;
monter des broches de contact (840) sur des patins de contact sélectionnés (825);
monter la plaque conductrice (822) à l'intérieur d'un boîtier (811) de telle sorte que les broches de contact montées (840) s'alignent avec les embases de connecteurs (818) dans le boîtier (811) pour recevoir des connecteurs prêts à brancher ; et **caractérisé par** :
la fixation d'une partie de chacune desdites broches de contact (840) entre ladite plaque conductrice (822) et ladite plaque non conductrice (824).
